(19) Europäisches Patentamt / European Patent Office / Office européen des brevets

(11) **EP 4 369 005 A1**

(12) **EUROPEAN PATENT APPLICATION**

(43) Date of publication:
**15.05.2024 Bulletin 2024/20**

(21) Application number: **22206710.0**

(22) Date of filing: **10.11.2022**

(51) International Patent Classification (IPC):
**G01R 19/175** (2006.01)     **H01L 29/16** (2006.01)
**G01R 31/26** (2020.01)     **H10K 10/46** (2023.01)

(52) Cooperative Patent Classification (CPC):
**G01R 31/2621;** G01N 27/414; G01N 27/4146;
G01R 19/175; H10K 10/46

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Melexis Technologies NV
3980 Tessenderlo (BE)**

(72) Inventors:
• **PIETTE, Francois
  3980 Tessenderlo (BE)**

• **DE LOCHT, Cliff
  3980 Tessenderlo (BE)**
• **FANGET, Axel
  2022 Bevaix (CH)**
• **OTT, Andreas
  99099 Erfurt (DE)**
• **LAUTE, Andreas
  99099 Erfurt (DE)**
• **FREITAG, Thomas
  99099 Erfurt (DE)**

(74) Representative: **Winger
Mouterij 16 bus 101
3190 Boortmeerbeek (BE)**

(54) **DIRAC VOLTAGE MEASUREMENT OF A GRAPHENE FET**

(57)     A system (100) for measuring a Dirac voltage of a GFET (110) which comprises: a bias voltage generator (120) configured for generating a toggling signal; a multiplier (140) configured for multiplying an electrical signal which is a function of a channel current of the GFET with a waveform alternating between two predefined values synchronously with the toggling signal; wherein a first integrator (130) is configured for integrating the electrical signal from the multiplier (140), and wherein if more integrators (130) are present, linear combinations of output signals of the integrators are provided to the further integrators (130); a summator (150) configured for summing the toggling signal and an integration signal, or a processed version thereof, wherein the integration signal is obtained by linearly combining outputs of the one or more integrators (130) and for outputting the sum to a gate of the GFET.

Fig. 3

EP 4 369 005 A1

**Description**

**Field of the invention**

The invention relates to the field of graphene field effect transistors (GFETs). More specifically it relates to a system for measuring the Dirac voltage of the GFET.

**Background of the invention**

The classical method for measuring the Dirac point of a GFET is to sweep the gate voltage and to measure the source drain current through the GFET. The Dirac point is the gate voltage where the current is minimum.

US8638163B2 discloses a device and method wherein a semiconductor device is used for generating a test voltage. A graphene transistor is configured to receive a gate-source voltage based on the test voltage, and a detector is configured to detect whether the gate-source voltage is a Dirac voltage of the graphene transistor. The detector therefore detects whether the graphene transistor is turned off or not based on the drain source voltage and/or the drain source current.

In both cases the Dirac point is obtained by ramping the gate voltage and by determining a level crossing, what is usually time consuming.

Thus, there is a need for an alternative system for determining the Dirac point of a GFET.

**Summary of the invention**

It is an object of embodiments of the present invention to provide a good system for determining the Dirac voltage of a GFET.

The above objective is accomplished by a method and device according to the present invention.

Embodiments of the present invention relate to a system for measuring a Dirac voltage of a graphene field effect transistor. The system comprises the graphene field effect transistor, a bias voltage generator configured for generating a toggling signal, toggling between plus and minus a predefined bias voltage $v_G$ around a given bias point, one or more integrators, a waveform generator for generating a waveform alternating between plus and minus a predefined value A which alternates synchronously with the toggling signal, and a multiplier 140 configured for generating an electrical signal by multiplying an electrical signal which is a function of a channel current of the graphene field effect transistor, with the waveform. Synchronously thereby means that there can be a phase shift between the alternating waveform and the toggling signal but that the frequency is the same. In a preferred embodiment the predefined value A is equal to 1, thus the waveform of the waveform generator is toggling between +1 and -1. In embodiments of the present invention a trans-impedance amplifier may be connected to the GFET drain before the multiplier 140. The first integrator, of the one or more integrators, is configured for integrating the electrical signal from the multiplier. If more integrators are present, linear combinations of output signals of the integrators are provided to the further integrators. The system, furthermore, comprises a summator configured for summing the toggling signal of the bias voltage generator and an integration signal, or a processed version thereof, wherein the integration signal is obtained by linearly combining outputs of the one or more integrators. The output of the summator is electrically connected with the gate of the graphene field effect transistor.

It is an advantage of embodiments of the present invention that from the integration signal or from the processed version of the integration signal the Dirac voltage of the GFET can be obtained.

In embodiments of the present invention the system comprises a sample and hold circuit for sampling and holding the integration signal for obtaining the processed version of the integration signal.

In embodiments of the present invention the system comprises exactly one integrator.

In embodiments of the present invention the system comprises exactly two integrators wherein an input signal of the second integrator is the sum of an output signal of the first integrator and an output signal of the second integrator multiplied with a predefined constant $a_1$.

In embodiments of the present invention the predefined bias voltage is such that the sum obtained by the summator is inside a quadratic region of the graphene field effect transistor characteristic.

In embodiments of the present invention the predefined bias voltage is such that the sum obtained by the summator in a linear region of the graphene field effect transistor characteristic.

In embodiments of the present invention in a first stage the predefined bias voltage is such that the sum obtained by the summator is in the linear region of the graphene field effect transistor characteristic and wherein in a second stage the predefined bias voltage is such that the sum obtained by the summator is inside a quadratic region of the graphene field effect transistor characteristic.

In embodiments of the present invention the one or more integrators are continuous time integrators.

In embodiments of the present invention the one or more integrators are discrete time integrators.

In embodiments of the present invention the system comprises a quantizer configured for quantizing the integrator signal at a predefined sampling frequency, and a digital to analog converter for converting the quantized signal into an analog signal for summing with the toggling signal at the summator.

It is an advantage of embodiments of the present invention that the Dirac voltage can be obtained from the quantized signal by filtering the quantized signal.

In embodiments of the present invention the system comprises a decimation filter configured for filtering the quantized signal.

In embodiments of the present invention the quantizer is a 1-bit quantizer.

In embodiments of the present invention the digital to analog converter is toggling between a first predefined reference voltage for a digital zero input and a second predefined reference voltage for a digital one input wherein the first reference voltage and the predefined bias voltage are selected such that toggling with the predefined bias voltage results in a voltage in the left linear region and a voltage in the right linear region and wherein the second reference voltage and the predefined bias voltage are selected such that toggling with the predefined bias voltage results in a voltage in the left linear region and a voltage in the right linear region of said graphene field effect transistor.

Such a system, in accordance with embodiments of the present invention, is preferably implemented for a graphene field effect transistor which has a substantial symmetry of the linear regions around the Dirac point.

In embodiments of the present invention the digital to analog converter is toggling between a first predefined reference voltage for a digital zero input and a second predefined reference voltage for a digital one input wherein the first reference voltage and the predefined bias voltage are selected such that toggling with the predefined bias voltage results in a voltage in the left part of a quadratic region and a voltage in the same left part of said quadratic region and wherein the second reference voltage and the predefined bias voltage are selected such that toggling with the predefined bias voltage results in a voltage in the right part of said quadratic region and a voltage in the same right part of said quadratic region of said graphene field effect transistor.

In embodiments of the present invention the quantizer is a multi-bit quantizer with a predefined number of $N_q$ bits, and the digital to analog converter also has $N_q$ bits.

In embodiments of the present invention in the quadratic region around the Dirac voltage a quadratic approximation of the drain source current Id through the graphene field effect transistor and the gate voltage is valid.

It is an advantage of embodiments of the present invention that the multi bit approach allows to search for the Dirac point in a wide range. In embodiments of the present invention the initial settling of the loop may for example take care of the initial guess and eventually, the DAC may toggle between 2 or 3 levels only.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.


**Brief description of the drawings**


FIG. 1 shows the GFET drain-source current versus gate voltage and an approximation thereof.

FIG. 2 shows a schematic drawing of a device integrating the GFET current for a system in accordance with embodiments of the present invention.

FIG. 3 shows a basic first order measurement loop of a system for measuring a Dirac voltage, in accordance with embodiments of the present invention.

FIG. 4 shows a block diagram of a first order linear system in accordance with embodiments of the present invention.

FIG. 5 shows a schematic drawing of a second order system in accordance with embodiments of the present invention.

FIG. 6 shows a block diagram of a second order system in accordance with embodiments of the present invention.

FIG. 7 shows the output voltage of a system with large gain modulation of a second order system with a bandwidth of 70 Hz in accordance with embodiments of the present invention.

FIG. 8 shows a zoomed-in version of FIG. 7.

FIG. 9 shows the frequency response of the second order system which was also used for obtaining the simulation results of FIG. 7.

FIG. 10 shows the output voltage as function of time of a system with small gain modulation of a second order system with a bandwidth of 70 Hz in accordance with embodiments of the present invention.

FIG. 11 shows a zoomed-in version of FIG. 10.

FIG. 12 shows the frequency response of a system with large gain modulation of a second order system with a bandwidth of 7 Hz in accordance with embodiments of the present invention.

FIG. 13 shows the output voltage of the system of FIG. 12.

FIG. 14 shows a zoomed-in version of FIG. 13.

FIG. 15 shows a schematic diagram of an exemplary system for measuring a Dirac voltage of a graphene field effect transistor, comprising a 1-bit quantizer and digital to analog converter, in accordance with embodiments of the present invention.

FIG. 16 shows a GFET characteristic and its linear approximation used by a system comprising a quantizer and digital to analog converter, in accordance with embodiments of the present invention.

FIG. 17 shows the output of a decimation filter converted to voltage, of a system in accordance with embodiments of the present invention.

FIG. 18 shows a plot zoomed to the settled output of the decimation filter of FIG 17.

FIG. 19 shows a plot zoomed to the settled output of the decimation filter for reference voltages which are closer to the Dirac voltage compared to reference voltages used for obtaining the plot of FIG. 18.

FIG. 20 shows a schematic diagram of an exemplary system for measuring a Dirac voltage of a graphene field effect transistor, comprising a $N_q$-bit quantizer and $N_q$-bit digital to analog converter, in accordance with embodiments of the present invention.

FIG. 21 shows a plot of the decimation filter output in function of the sample number for a simulation illustrating the operation of a system comprising a $N_q$-bit quantizer and $N_q$-bit digital to analog converter in accordance with embodiments of the present invention.

FIG. 22 shows a plot zoomed to the settled output of the decimation filter of the same simulation as in FIG. 21.

FIG. 23 shows the 5-bit quantizer output in function of the sample number, of the same simulation as in FIG. 21.

Any reference signs in the claims shall not be construed as limiting the scope. In the different drawings, the same reference signs refer to the same or analogous elements.

## Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In embodiments of the present invention the GFET is integrated inside a closed loop-system acting as a low-pass filter which delivers an output voltage equal to the Dirac voltage of the GFET. The loop can be a sigma-delta modulator delivering a digital value of the Dirac voltage.

Where in embodiments of the present invention reference is made to the quadratic region of a GFET, reference is made to the region wherein the current vs. gate characteristic can be approximated by a second order curve.

Where in embodiments of the present invention reference is made to the linear region of a GFET, reference is made to the region wherein the current vs. gate characteristic can be approximated by two linear functions.

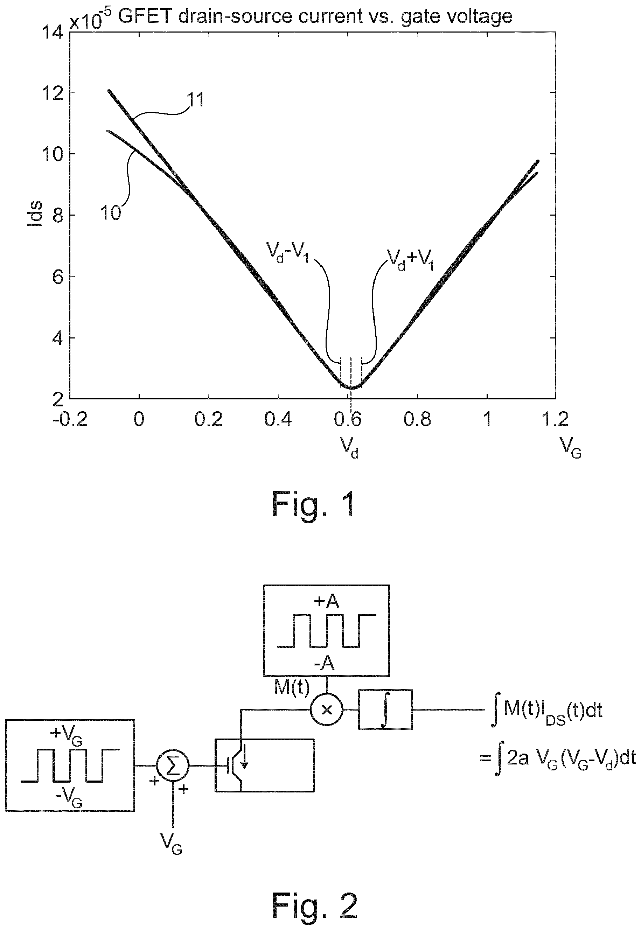

This is further explained with respect to FIG. 1.

FIG. 1 shows the MIT model 10 of a GFET. The model was presented in "Mackin, C. (2018) Graphene chemical and biological sensors: Modeling, systems, and applications. PhD thesis at the Massachusetts Institute of Technology". FIG. 1 shows a fitting 11 by a simple linear and quadratic approximation.

Around the Dirac point ($V_d$), the current vs. gate voltage characteristic can be approximated by a 2nd order curve:

$$I_{DS}(V_G) = I_{DS0} + \alpha \, (V_G - V_d)^2$$

Moving away from the Dirac point, the characteristic becomes more linear and can be approximated by 2 lines:

$$I_{DS}(V_G) = I_{DS1} - 2 \, \alpha \, V_1\big(V_G - (V_d - V_1)\big) \quad V_G \leq V_d - V_1$$

$$I_{DS}(V_G) = I_{DS1} + 2 \, \alpha \, V_1\big(V_G - (V_d + V_1)\big) \quad V_G \geq V_d + V_1$$

The junctions between the 3 parts are made at gate voltages $V_d$ - $V_1$ and $V_d$ + $V_1$. At those points, $I_{DS}$ = $I_{DS1}$ = $I_{DS0}$ + $\alpha$ ($V_1$)$^2$ and the slope (transconductance) is $2\alpha V_1$.

$$I_{DS}(V_G) = \{I_{DS1} - 2 \, \alpha \, V_1\big(V_G - (V_d - V_1)\big) \, if \, V_G \\ \leq V_d - V_1; \, I_{DS0} + \alpha \, (V_G - V_d)^2 \, if \, V_d - V_1 < V_G \\ < V_d + V_1; \, I_{DS1} + 2 \, \alpha \, V_1\big(V_G - (V_d + V_1)\big) \, if \, V_G \geq V_d + V_1\}$$

In a system according to embodiments of the present invention an analog low-pass filter loop automatically adjusts the gate voltage to the Dirac point. The advantage of this approach is that a low-noise, high-resolution measurement of the Dirac point can be obtained in approximately the same time as the cited prior art systems would take for each single step of their gate voltage ramp. In embodiments of the present invention a simple analog circuit / digital circuit can be used what results in a low energy consumption.

A system 100 for measuring a Dirac voltage of a graphene field effect transistor 110 according to embodiments of the present invention comprises the graphene field effect transistor 110, and a bias voltage generator 120 configured for generating a toggling signal, toggling between plus and minus a predefined bias voltage $v_G$ around a given bias point. The bias point is thus the average level of the toggling signal generated by the bias voltage generator. The given bias point may for example be zero volt. The invention is, however, not limited thereto. The given bias point may also be different from zero.

The system 100, moreover, comprises a multiplier 140 configured for generating an electrical signal by multiplying an electrical signal which is a function of a channel current Ic of the graphene field effect transistor 110, with a waveform alternating between two predefined values +A and -A which alternates synchronously with the toggling signal. Depending on the frequency of the toggling gate voltage and the characteristic of the GFET (frequency response), the alternating waveform applied to the multiplier could thereby be delayed (phase shifted) with respect to the gate voltage toggling signal. The predefined value A may for example be equal to 1. The invention is, however, not limited thereto. Also other values of A are possible. The factor A is a multiplication factor for the signal to be integrated. This signal can be the GFET drain current, a multiplication of the GFET drain current, the output of a trans-impedance amplifier. This signal is integrated by an integrator which also has a gain factor. In embodiments of the present invention A is selected such that the product of all multiplication factors applied to the GFET signal do not lead to saturation of the first integrator at any time. This total gain factor impacts the loop bandwidth and stability. The feedback or feedforward factors are preferably chosen to achieve the desired bandwidth and stability taking into account the GFET characteristic and all multiplicative factors involved in the integration of the GFET signal. In embodiments of the present invention A may for example be in a range between 0.001 and 1000.

The system 100, moreover, comprises one or more integrators 130 wherein a first integrator 130, of the one or more integrators 130, is configured for integrating the electrical signal from the multiplier 140, and wherein if more integrators 130 are present, linear combinations of output signals of the integrators are provided to the further integrators 130.

The system 100, moreover, comprises a summator 150 configured for summing the toggling signal of the bias voltage generator 120 and an integration signal, or a processed version thereof, wherein the integration signal is obtained by linearly combining outputs of the one or more integrators 130.

In embodiments of the present invention the system comprises a sample and hold circuit for sampling and holding the integration signal for obtaining the processed version of the integration signal.

In embodiments of the present invention the integration signal may be sampled before toggling from -A to +A (or from +A to -A) of the toggling signal applied to the multiplier and held for one full period of the toggling signal applied to the multiplier (same frequency as the toggling voltage applied to the gate but possible delay) so until the next toggling from -A to +A (or from +A to -A). The invention is, however, not limited thereto. A sample and hold circuit is not strictly required and if a sample and hold circuit is present, the sample moment may be selected different as specified above.

In embodiments of the present invention the last integrator in the loop may be implemented with a switched-capacitor circuit for providing the sample and hold functionality.

In such a system, according to embodiments of the present invention, a loop is formed. In order for the loop to converge to a stable gate voltage at the Dirac point, the low-pass filter loop has to integrate a quantity that is 0 when the gate voltage is at the Dirac point and which has a linear dependency on the gate voltage in the neighborhood of the Dirac point.

In the vicinity of the Dirac point, the current vs. gate voltage characteristic is a $2^{nd}$-order curve so its derivative is a linear function of the gate voltage which is null at the Dirac point.

The loop could therefore process the quantity $\Delta I_{DS}(V_G) = I_{DS}(V_G + v_G) - I_{DS}(V_G - v_G)$ where $v_G$ is the predefined bias voltage so that the current difference can be expressed using the derivative of the current at $V_G$:

$$\Delta I_{DS}(V_G) = 2\,\alpha\,(V_G - V_d)\,(2\,v_G)$$

The system therefore has to process the difference between 2 current measurements performed at slightly different gate voltages. Those current measurements have to be performed in sequence. The gate voltage applied to the GFET can be periodically toggled between $V_G + v_G$ and $V_G - v_G$ and the difference can be computed inside the integrator by inverting the integrated current when $V_G - v_G$ is applied to the gate:

$$V_{Gate} = V_G + v_G \sum_n \left[ 1 - 2 \left( rect(t - n\,T) - rect\left(t - \left(n + \frac{1}{2}\right) T\right) \right) \right]$$
$$rect(t - n\,T) = \{0 \; t < nT \;\; 1 \; t \geq nT \}$$

$$M(t) = \sum_n \left[ 1 - 2 \left( rect(t - n\,T) - rect\left(t - \left(n + \frac{1}{2}\right) T\right) \right) \right]$$

$$\int M(t)\,dt = 0$$

$$M(t)^2 = 1$$

$M(t)$ is a square wave oscillating between A=+1 and -A=-1 with period $T$ and 50% duty-cycle.

$$\int M(t)\, I_{DS}(t)\, dt = \int M(t)\, [I_{DS}(V_G) + 2\,\alpha\,(V_G - V_d)\, M(t)\, v_G]\, dt$$

$$= I_{DS}(V_G) \int M(t)\, dt + \int 2\,\alpha\,(V_G - V_d)\, v_G\, M(t)^2\, dt$$

$$= \int 2\,\alpha\,(V_G - V_d)\, v_G\, dt$$

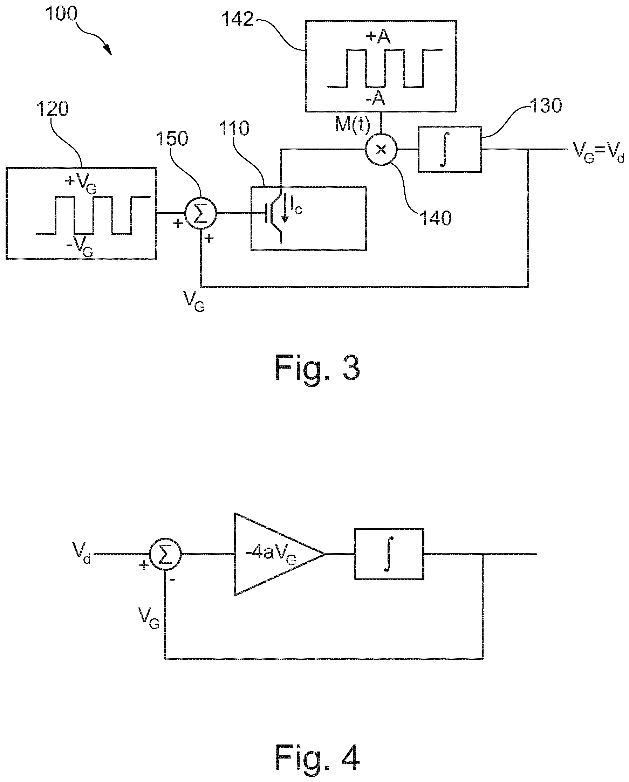

This integration of the GFET current is illustrated in FIG. 2. A basic first order measurement loop of a system for measuring a Dirac voltage, in accordance with embodiments of the present invention is illustrated in FIG. 3. It shows the GFET 110, the bias voltage generator 120, the first integrator 130, the multiplier 140, and the summator 150. In this example the bias point of the bias voltage generator is 0 and as a result thereof the integration signal will in this example be the Dirac voltage. If the bias point is different from zero, the integration signal will be the Dirac voltage minus the bias point.

The integrator integrates the difference between 2 GFET currents corresponding to 2 different gate voltages in order to integrate the slope of the current vs. gate voltage characteristic rather than the current itself.

The basic loop illustrated in FIG. 3 forms a 1st order linear system of which the block diagram is shown in FIG. 4.

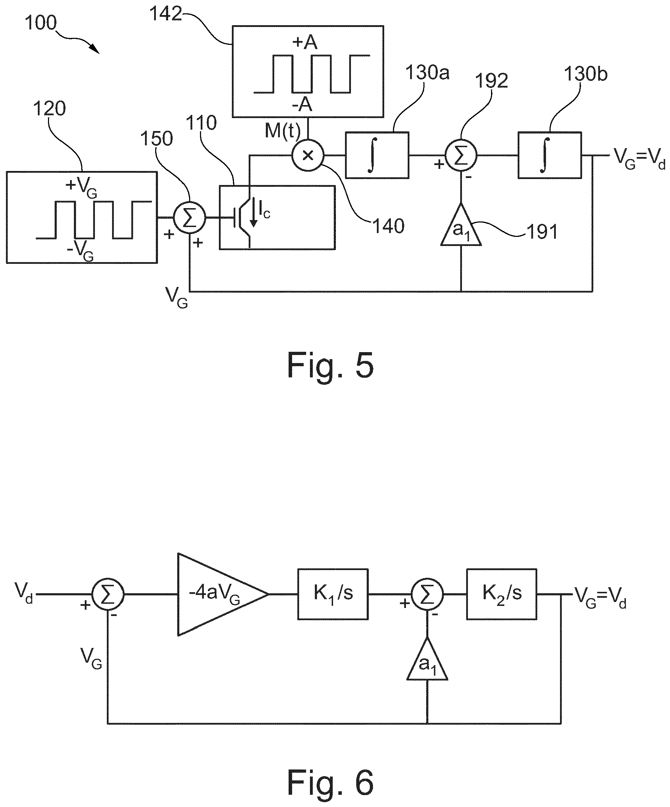

The loop can be extended up to any order. In embodiments of the present invention the system comprises exactly two integrators wherein an input signal of the second integrator is the sum of an output signal of the first integrator and an output signal of the second integrator multiplied with a predefined constant $a_1$. An example thereof is illustrated in FIG. 5. It shows the GFET 110, the bias voltage generator 120, the first integrator 130a, the second integrator 130b, the multiplier 140, the summator 150, a multiplier 191 for multiplying an output signal of the second integrator 130b with a predefined constant $a_1$, and a summator 192 for summing the output signal of the first integrator 130a and the output signal of the second integrator 130b.

The corresponding block diagram of the second order system is illustrated in FIG. 6. In this block diagram K1 holds the product multiplication factors like a possible trans-impedance factor, the amplitude of the multiplication waveform (A) and the capacitor used in the implementation of the of the continuous time integrator. K2 holds the time-constant of the second continuous time integrator.

In embodiments of the present invention the system has a predefined bias voltage modulation which is small enough such that the modulation is inside the quadratic region of the GFET characteristic.

The linear system description is valid when the predefined bias voltage $v_G > 2\,V_1$ and the gate voltages involved in the difference $I_{DS}(V_G + v_G)$ - $I_{DS}(V_G - v_G)$ are located in both linear regions of the GFET characteristic: $V_G - v_G \leq V_d - V_1$ and $V_G + v_G \geq V_d + V_1$.

In that case,

$$I_{DS}(V_G + v_G) - I_{DS}(V_G - v_G)$$
$$= I_{DS1} + 2\,\alpha\,V_1\big(V_G - (V_d + V_1)\big) - \big[I_{DS1} - 2\,\alpha\,V_1\big(V_G - (V_d - V_1)\big)\big]$$
$$= 4\,\alpha\,V_1(V_G - V_d)$$

The difference with respect to the previous case is that the gain is $4\,\alpha\,V_1$ instead of $4\,\alpha\,v_G$.

Using a large gate voltage modulation allows to search for the Dirac point over a large gate voltage range.

In embodiments of the present invention the loop can be implemented with continuous time integrator or discrete-time integrators.

The following Matlab simulation results show the behavior of the described 2nd-order system. The MIT model 10 used for the GFET has a Dirac point at $V_d$ = 0.61 V. The approximation 11 described in the document has the following parameters: $\alpha$ = 0.0016 $A/V^2$, $V_1$ = 0.0457 V, $I_{DS0}$ = 23 $\mu A$. These parameters are the parameters for the model in FIG. 1.

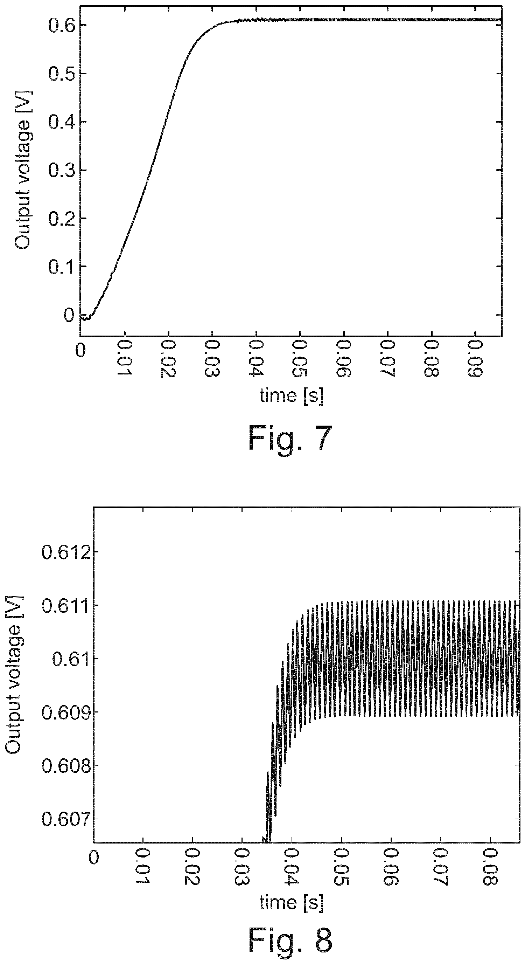

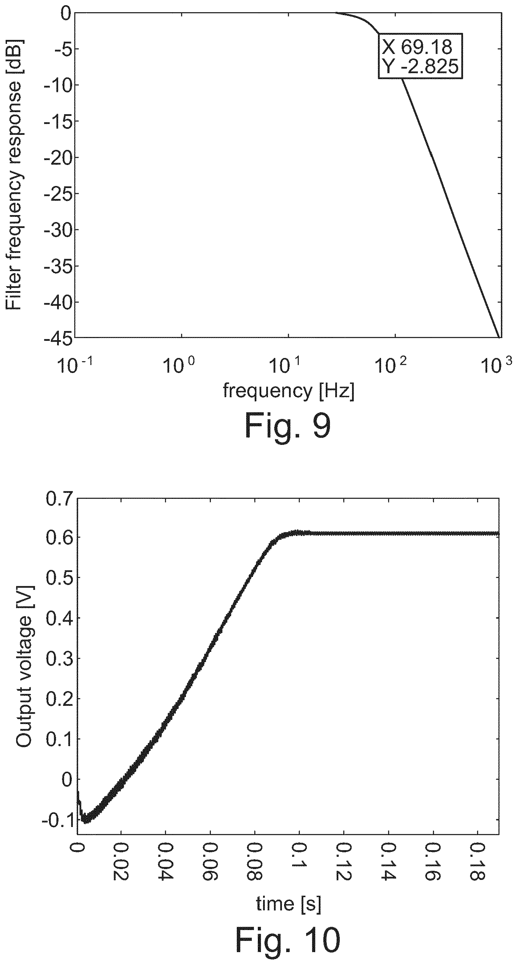

A first loop was constructed with 70 Hz bandwidth approximately. The predefined bias voltage was +/- 0.2V (i.e. large gate voltage modulation) at 1 kHz. The loop parameters were calculated considering the gain value $4\,\alpha\,V_1$. The simulation results in FIG. 7 and FIG. 8 show that the output of the filter reaches the Dirac voltage in less than 50 ms (see FIG. 7). There is +/- 1mV residual oscillation at 1 kHz (see FIG. 8 which is a zoomed-in version of FIG. 7 between 0.607 and 0.612 V). FIG. 9 shows the frequency response of the second order system.

The following simulation results show a second loop design with the same bandwidth of 70 Hz but using a predefined bias voltage $v_G$ of 0.01V (i.e. small gate voltage modulation) instead of 0.2V. The loop parameters were calculated considering the gain value $4\,\alpha\,v_G$. The integrator time constants are therefore different from the ones used with the larger bias voltage. The plot in FIG. 10 shows the settling at the output of the second order system with a small gate voltage modulation. The correct value is reached within 100 ms starting from discharged integrators. The loop first operates outside the quadratic GFET current region where the current difference $\Delta I_{DS}(V_G) = -2\,\alpha\,V_1$ is constant instead of being proportional to $V_G$. The loop only starts working when $V_G$ enters the quadratic region. This is further explained in the paragraph below.

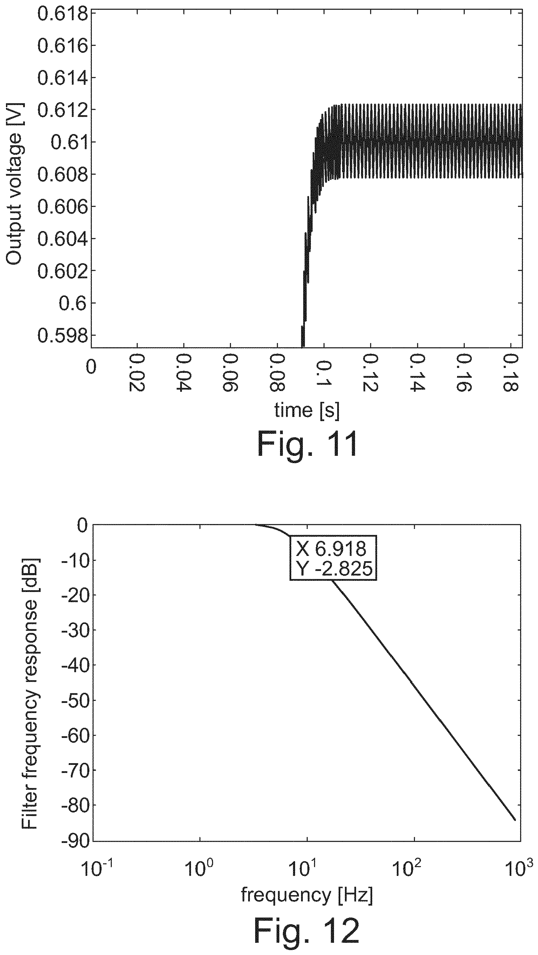

The residual oscillation of the second order system with 70 Hz bandwidth and small gate voltage modulation at 1 kHz has 2mV amplitude. This is illustrated in FIG. 11 which shows a zoomed-in version of FIG. 10 between 0.598 and 0.618 V.

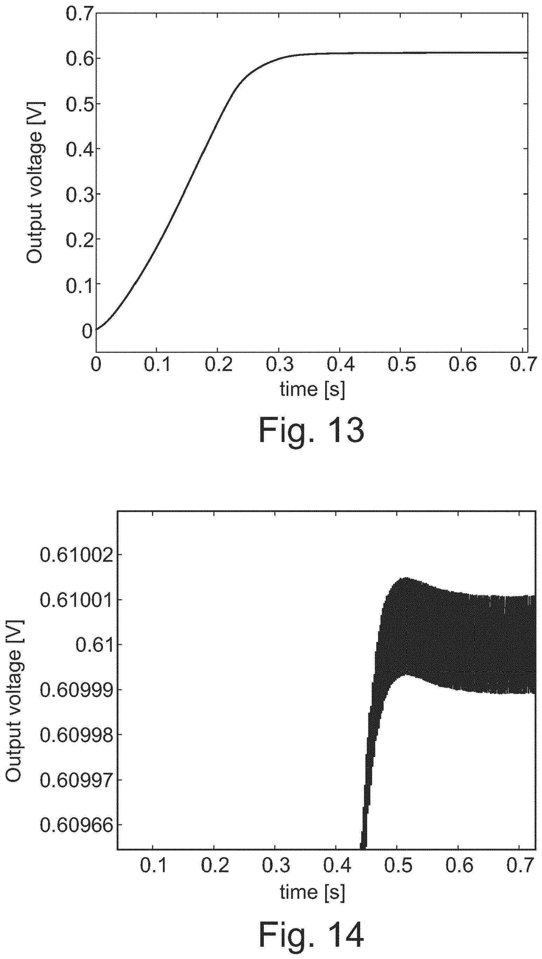

The oscillations can be reduced with a smaller filter bandwidth. FIGs. 12, 13 and 14 show the results for a loop with less than 7 Hz bandwidth and large gate signal modulation. The filter settles within 500 ms with 15 $\mu V$ residual oscillation. FIG. 12 shows the frequency response of the 2nd-order system with 7Hz bandwidth and large gate voltage modulation. FIG. 13 shows a Matlab simulation result illustrating the settling of the 7Hz-bandwidth, 2nd-order system with large gate voltage modulation. FIG. 13 shows a Matlab simulation result illustrating the residual oscillation at the output of the 7Hz-bandwidth, 2nd-order system with large gate voltage modulation. The residual oscillation can be reduced by introducing the sample and hold circuit. It is, however, not strictly required.

In embodiments of the present invention the system 100 comprises a quantizer 160 which is configured for quantizing the integrator signal at a predefined sampling frequency. The system 100, moreover, comprises a digital to analog converter 170 for converting the quantized signal into an analog signal for summing with the toggling signal at the summator 150.

Thus, the low-pass filter loop is converted into sigma-delta modulator. This is possible because of the linear relationship between the current difference, $\Delta I_{DS}$, and the gate voltage.

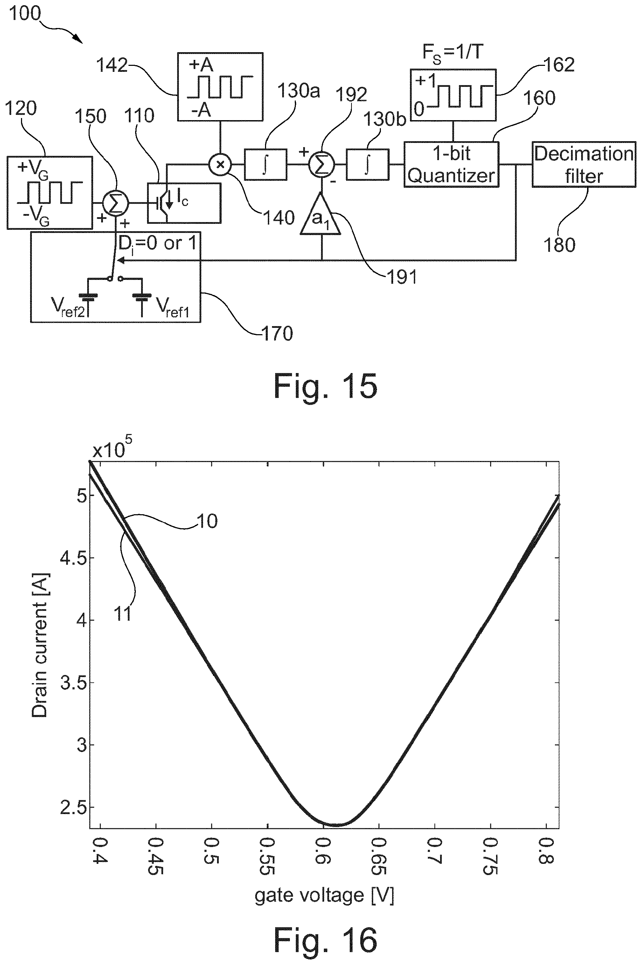

FIG. 15 shows a schematic diagram of an exemplary system for measuring a Dirac voltage of a graphene field effect transistor, comprising a 2nd-order sigma-delta ADC, in accordance with embodiments of the present invention.

The system 100 of FIG. 15 comprises a GFET 110, a bias voltage generator 120, a digital to analog converter 170, a summator 150 for summing the signal from the bias voltage generator 120 and the signal from the digital to analog converter 170. The output of the summator 150 is connected to the gate of the GFET 110. The system 100 furthermore comprises a waveform generator 142 configured for generating a waveform alternating between +A and -A, and a multiplier 140 configured for multiplying the waveform of the waveform generator with an electrical signal which is a function of a channel current of the GFET. The system, furthermore, comprises a first integrator 130a for integrating the signal from the multiplier 140 and a second integrator 130b for integrating the sum, obtained using a summator 192, of the signal from the first integrator 130a and the quantized output of the second integrator multiplied with a predefined factor a1 using a multiplier 191. The system, furthermore, comprises a 1-bit quantizer for quantizing the output signal of the second integrator 130b. The system, furthermore, comprises a decimation filter 180 at the output of the quantizer.

In the exemplary embodiment illustrated in FIG. 15, instead of smoothly adjusting the gate voltage to the Dirac point, the sigma-delta loop toggles the gate voltage $V_G$ between 2 fixed voltages, $V_{ref1}$ and $V_{ref2}$, within the region of validity of the linear relationship between the current difference and the gate voltage. The output of the 1-bit quantizer is, therefore, connected to a switch of the digital to analog converter 170 which switches between $V_{ref1}$ and $V_{ref2}$ and connects them alternatingly to the summator 150.

The GFET is then operated at 4 possible different voltages only: $V_{ref1} \pm v_G$ and $V_{ref2} \pm v_G$, wherein $v_G$ is the predefined voltage of the bias voltage generator 120. Those will generate only 2 different values for the current difference:

$$\Delta I_{DS1} = \Delta I_{DS}(V_{ref1}) = I_{DS}(V_{ref1} + v_G) - I_{DS}(V_{ref1} - v_G)$$

$$\Delta I_{DS2} = \Delta I_{DS}(V_{ref2}) = I_{DS}(V_{ref2} + v_G) - I_{DS}(V_{ref2} - v_G)$$

In order for a linear relationship to be valid, the gate voltages must be chosen as follows. If one uses a small gate voltage modulation (i.e. within the quadratic region of the GFET), $v_G$, all 4 gate voltages have to be in the central quadratic part of the GFET characteristic. In embodiments of the present invention small $v_G$ signal modulation is used in the quadratic region so that at the first predefined voltage, the gate voltage is toggling between 2 levels both at the left side of the Dirac point (the gate voltage is smaller than the Dirac voltage) and at the second predefined voltage, both levels will be at the right side of the Dirac point (the gate voltage is larger than the Dirac voltage).

In order for a linear relationship to be valid, if one uses a large gate voltage modulation (i.e. within the linear region of the GFET), $v_G$, all 4 gate voltages have to be outside the central quadratic part of the GFET characteristic:

$$V_{ref1} + v_G > V_d \qquad \text{(right linear region)}$$

$$V_{ref1} - v_G < V_d \qquad \text{(left linear region)}$$

$$V_{ref2} + v_G > V_d \qquad \text{(right linear region)}$$

$$V_{ref2} - v_G < V_d \qquad \text{(left linear region)}$$

In embodiments of the present invention the sigma-delta loop is sampling at the gate voltage modulation frequency $\left(F_s = \dfrac{1}{T}\right)$. This is illustrated by the sampling trigger signal 162 in FIG. 15. The sigma-delta loop delivers a bit stream alternating between 0 and 1. Let D be the ratio between the number of 1s and the total number of bits in the bit stream.

The sigma delta loop will adjust D such that the average of $\Delta I_{DS}$ is 0. $\Delta I_{DS}$ thereby is proportional to the slope of the GFET $I_{DS}$ vs. $V_G$ characteristic and becomes 0 at the Dirac voltage. The sigma-delta modulator generates its feedback signal such that the quantity that is integrated by the integrator is 0 in average.

$$\underline{I_{DS}} = D\,\Delta I_{DS2} + (1 - D)\,\Delta I_{DS1}$$

Supposing large gate voltage modulation:

$$\underline{I_{DS}} = D\,4\,\alpha\,V_1\left(V_{ref2} - V_d\right) + (1 - D)4\,\alpha\,V_1\left(V_{ref1} - V_d\right)$$

$\underline{I_{DS}} = 0$, therefore:

$$D\left(V_{ref2} - V_d\right) + (1 - D)\left(V_{ref1} - V_d\right) = 0$$

$$D\left(V_{ref2} - V_{ref1}\right) + V_{ref1} - V_d = 0$$

$$V_d = D\left(V_{ref2} - V_{ref1}\right) + V_{ref1}$$

The invention is not limited to sigma-delta modulators of the second order. Also sigma delta modulators of different orders may be used.

In embodiments of the present invention the integrators can be continuous-time of discrete-time integrators.

A Matlab simulation of an exemplary system, in accordance with embodiments of the present invention and illustrated in FIG. 15, applied to the GFET described by the MIT model has been executed. The Dirac point is at 0.61V and the limit of the quadratic region is $V_1 = 0.045$V.

If the converter is able to make accurate conversions over the full reference voltage range, from $V_{ref1}$ to $V_{ref2}$, the system is able to measure a Dirac voltage in the range from $V_{ref1}$ to $V_{ref2}$.

If the system is operated with a large gate modulation, the following conditions have to be fulfilled:

$V_{ref1} + v_G$ should be in the right linear region, hence:

$$V_{ref1} + v_G \geq V_{ref2} + V_1 \Rightarrow v_G \geq V_{ref2} - V_{ref1} + V_1$$

$V_{ref1} - v_G$ should be in the left linear region, hence:

$$V_{ref1} - v_G \leq V_{ref1} - V_1 \Rightarrow v_G \geq V_1$$

$v_{ref2}$ + $v_G$ should be in the right linear region, hence:

$$V_{ref2} + v_G \geq V_{ref2} + V_1 \Rightarrow v_G \geq V_1$$

$v_{ref2}$ - $v_G$ should be in the left linear region, hence:

$$V_{ref2} - v_G \leq V_{ref1} - V_1 \Rightarrow v_G \geq V_{ref2} - V_{ref1} + V_1$$

Therefore, in this exemplary embodiment of the present invention, the predefined bias voltage, also referred to as the modulation voltage, $v_G$ must meet the following condition:

$$v_G \geq V_{ref2} - V_{ref1} + V_1$$

For the simulation, the following values have been used: $V_{ref1}$ = 0.55 V, $v_{ref2}$ = 0.65 V and $v_G$ = 0.145V. The sample frequency $F_s$ = 1 kHz. In embodiments of the present invention the system comprises a decimation filter. The decimation filter may for example be a sinc3 filter with an over-sampling rate of 256.

In view of the values given above, the GFET is operated at the following gate voltages:

$$V_{ref1} + v_G = 0.695 \text{ V}$$

$$V_{ref1} - v_G = 0.405 \text{ V}$$

$$V_{ref2} + v_G = 0.795 \text{ V}$$

$$V_{ref2} - v_G = 0.505 \text{ V}$$

It can be seen on the plot of FIG. 16 that those values are at the limit of the linear approximation. In the plot the drain current is shown in function of the drain current for the accurate model 10 and the approximation 11. The output of the decimation filter gives a Dirac point measurement at 0.6099V.

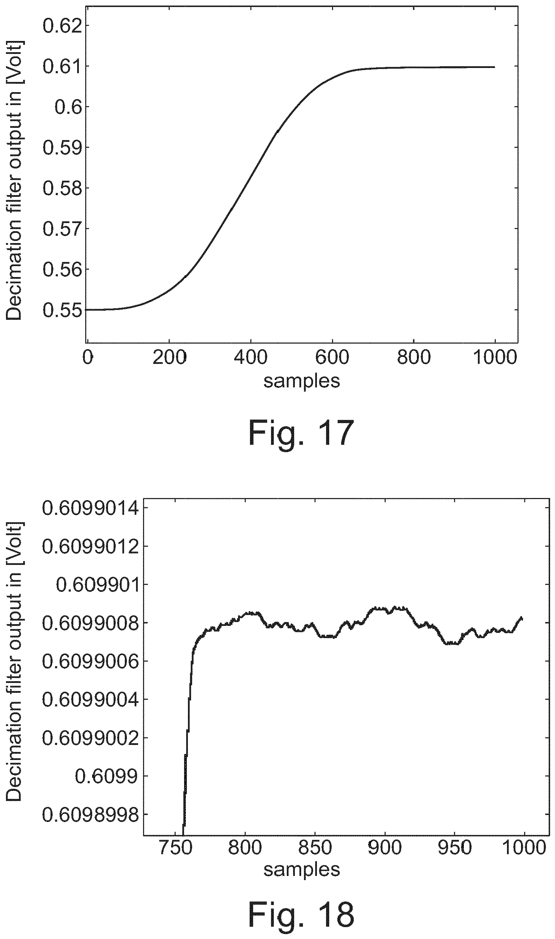

FIG. 17 shows the output of the decimation filter converted to voltage. The output of the filter settles within 3*256 samples corresponding to a settling time of 768 ms.

FIG. 18 shows a plot zoomed to the settled output of the decimation filter.

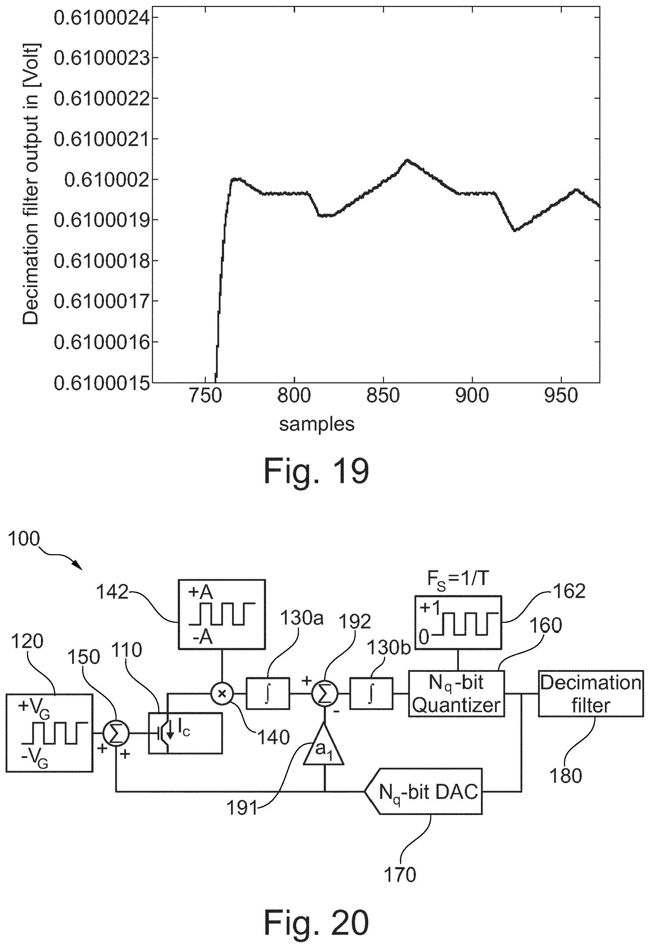

In an alternative embodiment of the present invention the reference voltages may be selected closer to the actual Dirac voltage. The following values may for example be selected: $V_{ref1}$ = 0.58 V, $V_{ref2}$ = 0.63 V and $v_G$ = 0.095V. In this example the GFET is operated at 4 gates voltages where the linear approximation holds better which yields a better estimation of the Dirac point. This is illustrated in FIG. 19 which shows a plot zoomed to the settled output of the decimation filter for the values cited above.

In embodiments of the present invention the quantizer 160 is a multi-bit quantizer with a predefined number of $N_q$ bits, wherein the digital to analog converter 170 has $N_q$ bits. An exemplary embodiment of such a system is shown in FIG. 20. The schematic diagram is similar to the schematic in FIG. 15 except for the fact that the quantizer is a $N_q$ bits quantizer and the digital to analog converter 170 has $N_q$ bits.

The multi-bit approach allows to search for the Dirac point in a wide range. In embodiments of the present invention the initial settling of the loop will take care of the initial guess of the Dirac point and eventually, the DAC will toggle between 2 or 3 levels only.

In embodiments of the present invention the multi-bit quantizer inside the sigma-delta loop is a low-resolution ADC. In embodiments of the present invention it is not just converting the output of the current integrator but a linear combination of the outputs of several integrators. In the example the output voltage of the second integrator is converted.

In embodiments of the present invention the output of the low-resolution multi-bit quantizer is directly connected to the low-resolution DAC without any processing by a control circuit configured to determine a voltage value applied to a control electrode of the control circuit.

As explained earlier the linear relationship between the current differences $\Delta I_{DS}$ and the 2 reference voltages

$V_{ref1}$, $V_{ref2}$ must be valid in order for the single-bit sigma-delta to deliver the correct value for the Dirac voltage.

The reference voltages can be extended beyond the regions of validity of the linear relationship if a multi-bit quantizer is used in the sigma-delta loop.

Instead of feeding back only 2 different gate voltages at the extremes of the $[V_{ref1};V_{ref2}]$ range, the loop will feedback $2^{N_q}$ different possible DAC voltages which are uniformly spread over the range $[V_{ref1};V_{ref2}]$, $N_q$ being the number of bits of the quantizer used inside the loop. After some settling time, the loop will automatically converge to a situation where the feedback gate voltage will toggle between a few of those possible feedback voltages only, all being located in the neighborhood of the Dirac voltage. In embodiments of the present invention the number of bits of the quantizer is chosen such that the several consecutive DAC voltages are inside the region of validity of the linear relationship between the current difference and the gate voltage.

The following simulation illustrates the operation of a multi-bit sigma-delta with small gate voltage modulation ($v_G$ = 5mV) able to give a digital code for the Dirac voltage in the range from 0V to 1V using a 5-bit quantizer and a 32-level DAC. The GFET model is the same as before. For small gate modulation, the current difference is linear vs. the gate voltage in the gate voltage range $[V_d - 0.045 ; V_d + 0.045]$. The DAC step is 1V/32 = 30 mV so that 2 or 3 DAC levels are inside that gate voltage range.

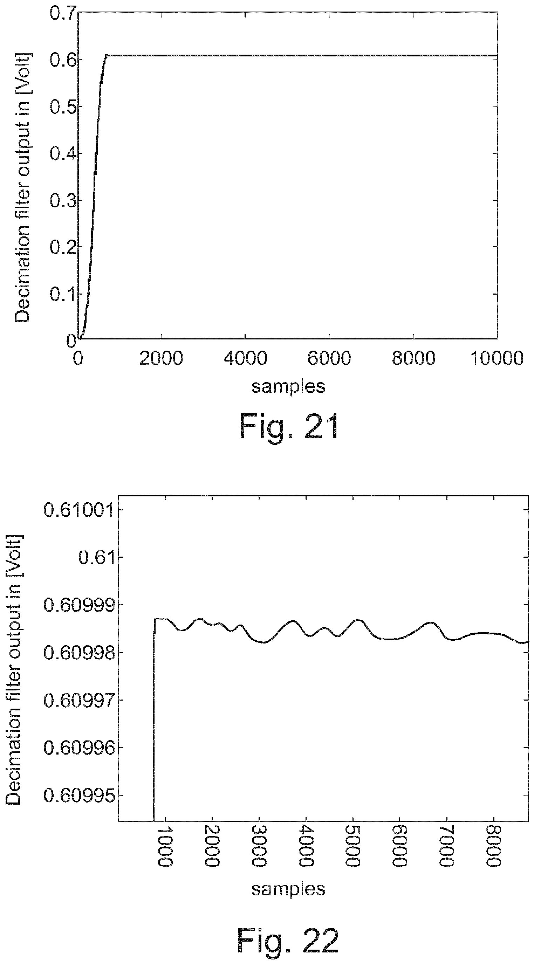

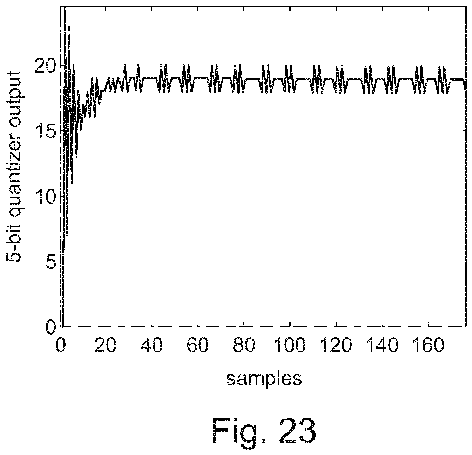

FIG. 21 shows a plot of the decimation filter output in function of the sample number. FIG. 22 shows a zoom to the output of the decimation filter. FIG. 23 shows the 5-bit quantizer output in function of the sample number.

With a small vG modulation signal, preferably there are several consecutive DAC voltages inside the quadratic region of the GFET IDS vs. $V_G$ characteristic so that the slope (the quantity that is integrated) is proportional to the applied gate voltage. That is the condition to form a linear feedback system and have an accurate measurement of the Dirac voltage as the successive DAC voltages. Indeed several DAC voltage outputs Vdac+/-vG are preferably in the quadratic region.

Note that the system will likely start in the linear region where the slope is constant. At that moment, there will be no actual feedback but the integrators will make the DAC voltage go to the direction of the Dirac voltage. It is only when the DAC voltage enters the curved part of the characteristic that there will be an actual feedback signal and that the loop will settle. The closer to a $2^{nd}$ order characteristic, the more accurate the measurement of the Dirac point.

The system 100 may comprise an upper system (e.g. a controller) for selecting the reference voltages of the system 100 so that the loop always starts in a first stage wherein the predefined bias voltage $v_G$ is selected such that the sum obtained by the summator is in a linear region of the graphene field effect transistor characteristic and settles down to a first Dirac voltage that is preferably in the quadratic region. In a second stage the upper system is configured for selecting the predefined bias voltage such that the sum obtained by the summator is inside the quadratic region of the graphene field effect transistor characteristic. The system then settles down to a second Dirac voltage which may be more or at least as accurate as the first obtained Dirac voltage. Thus, a system is obtained which performs the Dirac point measurement in a two stage approach.

**Claims**

1. A system (100) for measuring a Dirac voltage of a graphene field effect transistor (110), the system comprising:

   - the graphene field effect transistor (110),
   - a bias voltage generator (120) configured for generating a toggling signal, toggling between plus and minus a predefined bias voltage $v_G$ around a given bias point,
   - one or more integrators (130),
   - a multiplier (140) configured for generating an electrical signal by multiplying an electrical signal which is a function of a channel current of the graphene field effect transistor (110), with a waveform alternating between two predefined values plus and minus A which alternates synchronously with the toggling signal,
   - wherein a first integrator (130), of the one or more integrators (130), is configured for integrating the electrical signal from the multiplier (140), and wherein if more integrators (130) are present, linear combinations of output signals of the integrators are provided to the further integrators (130),
   - a summator (150) configured for summing the toggling signal and an integration signal, or a processed version thereof, wherein the integration signal is obtained by linearly combining outputs of the one or more integrators (130) and configured for outputting the sum to a gate of the graphene field effect transistor.

2. A system (100) according to claim 1, the system comprising a sample and hold circuit for sampling and holding the integration signal for obtaining the processed version of the integration signal.

3. A system (100) according to claim 1, the system comprising exactly one integrator (130).

**4.** A system (100) according to claim 1, the system comprising exactly two integrators (130a, 130b) wherein an input signal of the second integrator (130b) is the sum of an output signal of the first integrator (130a) and an output signal of the second integrator multiplied with a predefined constant $a_1$.

**5.** A system (100) according to any of the previous claims, wherein the predefined bias voltage is such that the sum obtained by the summator is inside a quadratic region of the graphene field effect transistor characteristic.

**6.** A system (100) according to any of the claims 1 to 4, wherein the predefined bias voltage is such that the sum obtained by the summator is in a linear region of the graphene field effect transistor characteristic.

**7.** A system (100) according to any of the previous claims, wherein in a first stage the predefined bias voltage is such that the sum obtained by the summator is in a linear region of the graphene field effect transistor characteristic and wherein in a second stage the predefined bias voltage is such that the sum obtained by the summator is inside a quadratic region of the graphene field effect transistor characteristic.

**8.** A system (100) according to any of the previous claims, wherein the one or more integrators (130) are continuous time integrators.

**9.** A system (100) according to any of the claims 1 to 7, wherein the one or more integrators (130) are discrete time integrators.

**10.** A system (100) according to any of the previous claims, the system (100) comprising a quantizer (160) configured for quantizing the integrator signal at a predefined sampling frequency, and a digital to analog converter (170) for converting the quantized signal into an analog signal for summing with the toggling signal at the summator (150).

**11.** A system (100) according to claim 10, the system (100) comprising a decimation filter (180) configured for filtering the quantized signal.

**12.** A system (100) according to any of the claims 10 or 11, wherein the quantizer (160) is a 1-bit quantizer.

**13.** A system (100) according to any of the claims 10 to 12 wherein the digital to analog converter (170) is toggling between a first predefined reference voltage for a digital zero input and a second predefined reference voltage for a digital one input wherein the first and second reference voltages and the predefined bias voltage are selected such that toggling with the predefined bias voltage results in a voltage in the left linear region and a voltage in the right linear region of said graphene field effect transistor.

**14.** A system (100) according to any of the claims 10 to 12 wherein the digital to analog converter (170) is toggling between a first predefined reference voltage for a digital zero input and a second predefined reference voltage for a digital one input wherein the first reference voltage and the predefined bias voltage are selected such that toggling with the predefined bias voltage results in a voltage in the left part of a quadratic region and a voltage in the same left part of said quadratic region and wherein the second reference voltage and the predefined bias voltage are selected such that toggling with the predefined bias voltage results in a voltage in the right part of said quadratic region and a voltage in the same right part of said quadratic region of said graphene field effect transistor.

**15.** A system (100) according to claim 11 wherein the quantizer (160) is a multi-bit quantizer with a predefined number of $N_q$ bits, wherein the digital to analog converter (170) has $N_q$ bits.

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 23

Europäisches Patentamt
European Patent Office
Office européen des brevets

# EUROPEAN SEARCH REPORT

Application Number

EP 22 20 6710

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2013/069714 A1 (KIM HO-JUNG [KR] ET AL) 21 March 2013 (2013-03-21) * figures 1-13 * * paragraph [0049] – paragraph [0142] * ----- | 1-15 | INV. G01R19/175 H01L29/16 G01R31/26 H10K10/46 |
| A | US 5 039 941 A (CASTRO HERNAN A [US]) 13 August 1991 (1991-08-13) * figures 4, 5 * * column 4, line 28 – column 7, line 52 * ----- | 1-15 | |
| A | CN 115 032 515 A (BEIJING HUAFENG TEST & CONTROL TECH CO LTD) 9 September 2022 (2022-09-09) * the whole document * ----- | 1-15 | |

TECHNICAL FIELDS SEARCHED (IPC)

G01R
H01L
H10K
G01N

The present search report has been drawn up for all claims

| Place of search | Date of completion of the search | Examiner |
|---|---|---|
| Munich | 24 April 2023 | Colasanti, Katharina |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 20 6710

This annex lists the patent family members relating to the patent documents cited in the above-mentioned European search report.
The members are as contained in the European Patent Office EDP file on
The European Patent Office is in no way liable for these particulars which are merely given for the purpose of information.

24-04-2023

| Patent document cited in search report | | Publication date | Patent family member(s) | | Publication date |
|---|---|---|---|---|---|
| US 2013069714 | A1 | 21-03-2013 | CN | 103000220 A | 27-03-2013 |
| | | | JP | 6153708 B2 | 28-06-2017 |
| | | | JP | 6431941 B2 | 28-11-2018 |
| | | | JP | 2013065848 A | 11-04-2013 |
| | | | JP | 2017108166 A | 15-06-2017 |
| | | | KR | 20130030103 A | 26-03-2013 |
| | | | US | 2013069714 A1 | 21-03-2013 |
| US 5039941 | A | 13-08-1991 | NONE | | |
| CN 115032515 | A | 09-09-2022 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8638163 B2

**Non-patent literature cited in the description**

- Graphene chemical and biological sensors: Modeling, systems, and applications. **MACKIN, C.** PhD thesis. Massachusetts Institute of Technology, 2018